# EUROPEAN PATENT APPLICATION

(11) **EP 3 379 729 A1**
(43) Date of publication of application: **26.09.2018**
(21) Application number: 17161922.4
(22) Date of filing: 20.03.2017
(51) Int. Cl.: H04B 1/28, H04B 1/18, H04H 40/90, H03D 7/16, H04N 7/20

(54) **SIGNAL RECEIVER**

(71) Applicant: Rafael Microelectronics, Inc., Hsinchu County 30264 (TW)
(72) Inventor: Kan, Meng-Ping, Hsinchu County (TW); Hsieh, Chun-An, Hsinchu County (TW)
(74) Representative: Lang, Christian

(57) **Abstract**

A signal receiver includes a first mixer configured to mix its first input with its second input associated with an oscillating output of a frequency multiplier into an output, wherein the oscillating output of the frequency multiplier is generated based on an oscillating output of a first synthesizer, and the oscillating output of the frequency multiplier has a greater frequency than that of the oscillating output of the first synthesizer; a first splitter configured to split its input associated with the output of the first mixer into a first output and a second output; a first switch matrix configured to switch its first input associated with the first output of the first splitter into a first output; and a second switch matrix configured to switch its first input associated with the second output of the first splitter into a first output.

## Description

### BACKGROUND OF THE DISCLOSURE

### Field of the Disclosure

The present invention relates generally to a signal receiver, and more particularly to a signal receiver configured to be set in an outdoor unit to receive a signal from one or more satellites in a field of view of the signal receiver.

### Brief Description of the Related Art

Satellite television has become increasingly popular due to various contents. A satellite television system typically includes an antenna array configured to collect signals from satellites and a signal receiver containing amplifiers configured to amplify the collected signals, band-pass filters (BPF) configured to pass the collected signals at frequencies within a certain frequency range and to attenuate the collected signals at frequencies outside the certain frequency range, and mixers configured to convert the collected signals at radio frequencies into ones at base or intermediate frequencies. Thereby, the collected signals may be processed into optimum amplified signals in a base or intermediate frequency band so as to be demodulated in a set top box.

### SUMMARY OF THE DISCLOSURE

The present invention provides a signal receiver configured to be set in an outdoor unit to receive a signal from one or more satellites in a field of view of the signal receiver such that the signal can be conditioned and split in the outdoor unit to be passed to multiple indoor units in respective families, and each of the indoor units may include a splitter to split the signal received from the signal receiver set in the outdoor unit to be demodulated by multiple setup boxes in said each of the indoor units.

The signal receiver includes: a first synthesizer configured to generate an oscillating output having a first frequency; a first frequency multiplier configured to multiply the oscillating output of the first synthesizer into an oscillating output having a second frequency greater than the first frequency; a first mixer configured to mix its first input with its second input associated with the oscillating output of the first frequency multiplier into an output; a first splitter configured to split its input associated with the output of the first mixer into a first output and a second output; a first switch matrix configured to switch its first input associated with the first output of the first splitter into a first output; a second switch matrix configured to switch its first input associated with the second output of the first splitter into a first output; a second synthesizer configured to generate an oscillating output; a second mixer configured to mix its first input associated with the first output of the first switch matrix with its second input associated with the oscillating output of the second synthesizer into an output; a third synthesizer configured to generate an oscillating output; and a third mixer configured to mix its first input associated with the first output of the second switch matrix with its second input associated with the oscillating output of the third synthesizer into an output.

Further, the present invention provides a signal receiver with a single integrated-circuit (IC) chip, in which two multipliers are configured to multiply two oscillating outputs of two respective synthesizers by an integer, such as two or four, so as to generate the other two oscillating outputs at specific levels each passed to two mixers in the single integrated-circuit (IC) chip such that twice the difference of frequencies of the oscillating outputs of the two synthesizers may be outside of a frequency range of an output of each of the mixers in the single integrated-circuit (IC) chip. Thereby, the interference of the outputs of the mixers with the oscillating outputs of the synthesizers can be dramatically reduced.

The signal receiver includes: a synthesizer configured to generate an oscillating output; an in-phase/quadrature (I/Q) splitter configured to split its input associated with the oscillating output into an in-phase oscillating output and a quadrature oscillating output with phase difference of 90 degrees; a first mixer configured to mix its first input with its second input associated with the in-phase oscillating output of the in-phase/quadrature (I/Q) splitter into an output; a second mixer configured to mix its first input with its second input associated with the quadrature oscillating output of the in-phase/quadrature (I/Q) splitter into an output; a third mixer configured to mix its first input with its second input associated with the in-phase oscillating output of the in-phase/quadrature (I/Q) splitter into an output; a fourth mixer configured to mix its first input with its second input associated with the quadrature oscillating output of the in-phase/quadrature (I/Q) splitter into an output; a first image rejection filer configured to attenuate an image part of one of its two inputs associated with the outputs of the first and second mixers respectively and pass a real part of said one of its two inputs into a first image rejected signals, to attenuate an image part of the other one of its two inputs and pass a real part of the other one of its two inputs into a second image rejected signal and then to shift a phase of one of the first and second image rejected signals to be in phase with each other and to be combined into an output of the first image rejection filter; and a second image rejection filer configured to attenuate an image part of one of its two inputs associated with the outputs of the first and second mixers respectively and pass a real part of said one of its two inputs into a third image rejected signals, to attenuate an image part of the other one of its two inputs and pass a real part of the other one of its two inputs into a fourth image rejected signal and then to shift a phase of one of the third and fourth image rejected signals to be in phase with each other and to be combined into an output of the second image rejection filter.

These, as well as other components, steps, features, benefits, and advantages of the present disclosure, will now become clear from a review of the following detailed description of illustrative embodiments, the accompanying drawings, and the claims.

### BRIEF DESCRIPTION OF THE DRAWINGS

The drawings disclose illustrative embodiments of the present disclosure. They do not set forth all embodiments. Other embodiments may be used in addition or instead. Details that may be apparent or unnecessary may be omitted to save space or for more effective illustration. Conversely, some embodiments may be practiced without all of the details that are disclosed. When the same reference number or reference indicator appears in different drawings, it may refer to the same or like components or steps.

Aspects of the disclosure may be more fully understood from the following description when read together with the accompanying drawings, which are to be regarded as illustrative in nature, and not as limiting. The drawings are not necessarily to scale, emphasis instead being placed on the principles of the disclosure. In the drawings:
Fig. 1A illustrates a block diagram of a signal receiver in accordance with a first embodiment of the present invention;
Figs. 1B and 1C are block diagrams illustrating two different types of single integrated-circuit (IC) chips in accordance with a first embodiment of the present invention;
Fig. 1D illustrates a block diagram of another signal receiver in accordance with the first embodiment of the present invention.
Fig. 1E illustrates a block diagram of a signal receiver in accordance with a third embodiment of the present invention.
Fig. 2 illustrates packages for multiple single integrated-circuit (IC) chips in accordance with the first embodiment of the present application;
Fig. 3 illustrates a block diagram of a signal receiver in accordance with the first embodiment of the present invention;
Fig. 4 illustrates a block diagram of a signal receiver set in an outdoor unit to work with multiple indoor units in accordance with the first embodiment of the present invention;
Fig. 5 illustrates a block diagram of a signal receiver in accordance with the first embodiment of the present invention;
Fig. 6 illustrates a block diagram of a signal receiver in accordance with the first embodiment of the present invention;
Fig. 7 illustrates a block diagram of a signal receiver in accordance with a second embodiment of the present invention;
Fig. 8 illustrates a block diagram of a signal receiver set in an outdoor unit to work with multiple indoor units in accordance with the second embodiment of the present invention; and
Fig. 9 illustrates a block diagram of a signal receiver in accordance with the second embodiment of the present invention.

While certain embodiments are depicted in the drawings, one skilled in the art will appreciate that the embodiments depicted are illustrative and that variations of those shown, as well as other embodiments described herein, may be envisioned and practiced within the scope of the present disclosure.

### DETAILED DESCRIPTION OF THE INVENTION

Illustrative embodiments are now described. Other embodiments may be used in addition or instead. Details that may be apparent or unnecessary may be omitted to save space or for a more effective presentation. Conversely, some embodiments may be practiced without all of the details that are disclosed.

### First Embodiment

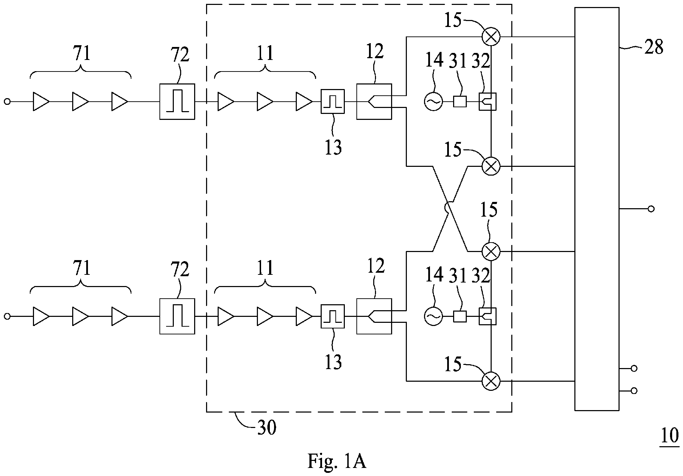

Fig. 1A illustrates a block diagram of a signal receiver in accordance with a first embodiment of the present invention. Referring to Fig. 1A, the signal receiver 10, such as low-noise block (LNB), is configured to be set in an outdoor unit to process vertically and horizontally polarized signals or right-hand and left-hand circularly polarized signals, collected by an antenna feed horn of the signal receiver 10 at a focal point of an antenna dish or reflector dish of the outdoor unit, from a satellite in a field of view of the signal receiver 10.

Referring to Fig. 1A, the signal receiver 10 may include two sets of multi-stage amplifiers 71 arranged in parallel, wherein each of the two sets of multi-stage amplifiers 71 includes multiple amplifiers coupled in series. Each of the amplifiers 71 in each set may be a low noise amplifier (LNA), for example, having its input to be amplified as an output of said each of the amplifiers 71. Accordingly, each of the two sets of multi-stage amplifiers 71 may have its input to be amplified stage by stage as an output of said each of the two sets of multi-stage amplifiers 71, and thus said each of the two sets of multi-stage amplifiers 71 has its output amplified with a low noise. The vertically polarized signal collected from the antenna feed horn may be transmitted to the input of a top one of the two sets of multi-stage amplifiers 71, and the horizontally polarized signal collected from the antenna feed horn may be transmitted to the input of a bottom one of the two sets of multi-stage amplifiers 71; alternatively, the right-hand circularly polarized signal collected from the antenna feed horn may be transmitted to the input of the top one of the two sets of multi-stage amplifiers 71, and the left-hand circularly polarized signal collected from the antenna feed horn may be transmitted to the input of the bottom one of the two sets of multi-stage amplifiers 71. The two sets of multi-stage amplifiers 71 may be two respective sets of three-stage amplifiers arranged in parallel, wherein each of the two sets of three-stage amplifiers includes three amplifiers coupled in series as shown in Fig. 1A. Alternatively, the two sets of multi-stage amplifiers 71 may be two respective sets of two-stage amplifiers arranged in parallel, wherein each of the two sets of two-stage amplifiers includes two amplifiers coupled in series. Alternatively, the two sets of multi-stage amplifiers 71 may be replaced with two respective sets of single-stage amplifier arranged in parallel.

Referring to Fig. 1A, the signal receiver 10 may include two band-pass filters (BPF) 72 arranged in parallel, a top one of which has its input coupled to the output of the top one of the two sets of multi-stage amplifiers 71 and a bottom one of which has its input coupled to the output of the bottom one of the two sets of multi-stage amplifiers 71. Each of the two band-pass filters (BPF) 72 may pass its input at frequencies within a certain frequency range and attenuate its input at frequencies outside the certain frequency range as an output of said each of the band-pass filters (BPF) 72.

Referring to Fig. 1A, the signal receiver 10 may include two sets of multi-stage amplifiers 11 arranged in parallel, a top one of which has its input coupled to the output of the top one of the two band-pass filters (BPF) 72 and a bottom one of which has its input coupled to the output of the bottom one of the two band-pass filters (BPF) 72. Each of the two sets of multi-stage amplifiers 11 includes multiple amplifiers coupled in series. Each of the amplifiers 11 in each set may be a low noise amplifier (LNA), for example, having its input to be amplified as an output of said each of the amplifiers 11. Accordingly, each of the two sets of multi-stage amplifiers 11 may have its input to be amplified stage by stage as an output of said each of the two sets of multi-stage amplifiers 11, and thus said each of the two sets of multi-stage amplifiers 11 has its output amplified with a low noise.

Referring to Fig. 1A, the signal receiver 10 may include two band-pass filters (BPF) 13 arranged in parallel, wherein the top one of the two band-pass filters (BPF) 13 has its input coupled to the output of the top one of the two sets of multi-stage amplifiers 11, and the bottom one of the two band-pass filters (BPF) 13 has its input coupled to the output of the bottom one of the two sets of multi-stage amplifiers 11. Each of the two band-pass filters (BPF) 13 may pass its input at frequencies within a certain frequency range and attenuate its input at frequencies outside the certain frequency range as an output of said each of the band-pass filters (BPF) 13.

Referring to Fig. 1A, the signal receiver 10 may include two splitters 12, i.e. power divider, arranged in parallel, wherein a top one of the two splitters 12 has its input coupled to the output of the top one of the two band-pass filters (BPF) 13 and a bottom one of the two splitters 12 has its input coupled to the output of the bottom one of the two band-pass filters (BPF) 13. Each of the two splitters 12 may split its input into two identities with substantially the same power at two respective outputs of said each of the splitters 12.

Referring to Fig. 1A, the signal receiver 10 may include two synthesizers 14, i.e., local oscillators (LO), a top one of which may generate an oscillating output within a frequency range between 1.5 GHz and 10.0 GHz and preferably between 4.0 GHz and 6.0 GHz, such as 4.875 GHz and a bottom one of which may generate an oscillating output within a frequency range between 1.5 GHz and 10.0 GHz and preferably between 4.0 GHz and 6.0 GHz, such as 5.3 GHz. The oscillating output of the top one of the two synthesizers 14 may have a different frequency from that of the oscillating output of the bottom one of the two synthesizers 14.

Referring to Fig. 1A, the signal receiver 10 may include two frequency multipliers 31, a top one of which may multiply the oscillating output of the top one of the two synthesizers 14 by an integer, such as two or four, into an oscillating output within a frequency range between 3.0 GHz and 20.0 GHz and preferably between 8.0 GHz and 12.0 GHz, such as 9.75 GHz, and a bottom one of which may multiply the oscillating output of the bottom one of the two synthesizers 14 by an integer, such as two or four, into an oscillating output within a frequency range between 3.0 GHz and 20.0 GHz and preferably between 8.0 GHz and 12.0 GHz, such as 10.6 GHz. The oscillating output of the top one of the two frequency multipliers 31 may have a greater frequency than that of the oscillating output of the top one of the two synthesizers 14. The oscillating output of the bottom one of the two frequency multipliers 31 may have a greater frequency than that of the oscillating output of the bottom one of the two synthesizers 14. The oscillating output of the top one of the two frequency multipliers 31 may have a different frequency from that of the oscillating output of the bottom one of the two frequency multipliers 31.

Referring to Fig. 1A, the signal receiver 10 may include two splitters 32, i.e. power dividers, a top one of which has its input coupled to the oscillating output of the top one of the two frequency multipliers 31 and a bottom one of which has its input coupled to the oscillating output of the bottom one of the two frequency multipliers 31. Each of the two splitters 32 may split its input into two identities with substantially the same power at two respective outputs of said each of the splitters 32.

Referring to Fig. 1A, the signal receiver 10 may include four mixers 15 arranged in parallel. A topmost one of the four mixers 15 may have its first input coupled to a top one of the two outputs of a top one of the two splitters 12 and its second input coupled to a top one of the two outputs of a top one of the two splitters 32 and mix its first and second inputs into an output. A second top one of the four mixers 15 may have its first input coupled to a top one of the two outputs of a bottom one of the two splitters 12 and its second input coupled to a bottom one of the two outputs of the top one of the two splitters 32 and mix its first and second inputs into an output. A second bottom one of the four mixers 15 may have its first input coupled to a bottom one of the two outputs of the top one of the two splitters 12 and its second input coupled to a top one of the two outputs of a bottom one of the two splitters 32 and mix its first and second inputs into an output. A bottommost one of the four mixers 15 may have its first input coupled to a bottom one of the two outputs of the bottom one of the two splitters 12 and its second input coupled to a bottom one of the two outputs of the bottom one of the two splitters 32 and mix its first and second inputs into an output. The two sets of multi-stage amplifiers 11, two splitters 12, two band-pass filters (BPF) 13, two synthesizers 14, two frequency multipliers 31, two splitters 32 and four mixers 15 may compose a radio-frequency (RF) module incorporated in a single integrated circuit chip 30.

Alternatively, referring to Fig. 1A, the splitters 32 may be omitted. The topmost one of the four mixers 15 may have its first input coupled to the top one of the two outputs of the top one of the two splitters 12 and its second input coupled to the output of the top one of the two frequency multipliers 31 and mix its first and second inputs into an output. The second top one of the four mixers 15 may have its first input coupled to the top one of the two outputs of the bottom one of the two splitters 12 and its second input coupled to the output of the top one of the two frequency multipliers 31 and mix its first and second inputs into an output. The second bottom one of the four mixers 15 may have its first input coupled to the bottom one of the two outputs of the top one of the two splitters 12 and its second input coupled to the output of the bottom one of the two frequency multipliers 31 and mix its first and second inputs into an output. The bottommost one of the four mixers 15 may have its first input coupled to the bottom one of the two outputs of the bottom one of the two splitters 12 and its second input coupled to the output of the bottom one of the two frequency multipliers 31 and mix its first and second inputs into an output. The two sets of multi-stage amplifiers 11, two splitters 12, two band-pass filters (BPF) 13, two synthesizers 14, two frequency multipliers 31 and four mixers 15 may compose a radio-frequency (RF) module incorporated in a single integrated circuit chip 30.

Thereby, referring to Fig. 1A, the signal receiver 10 is provided with the single integrated-circuit (IC) chip 30, in which the two multipliers 31 are configured to multiply the two oscillating outputs of the two respective synthesizers 14 by an integer, such as two or four, so as to generate the other two oscillating outputs at specific levels each passed to the second inputs of two of the mixers 15 such that twice the difference of frequencies of the oscillating outputs of the synthesizers 14 may be outside of a frequency range of the output of each mixer 15 in the single integrated-circuit (IC) chip 30. Accordingly, the interference of the outputs of the mixers 15 with the oscillating outputs of the synthesizers 14 can be dramatically reduced.

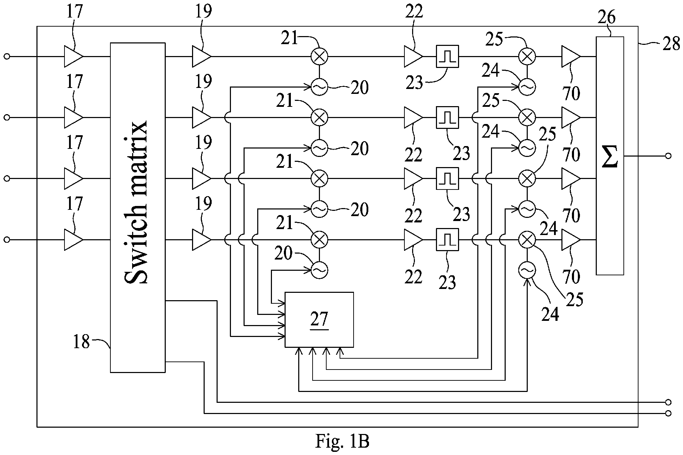

Fig. 1B is a block diagram illustrating a type of single integrated-circuit (IC) chip in accordance with a first embodiment of the present invention. Referring to Figs. 1A and 1B, the signal receiver 10 may include a single integrated-circuit (IC) chip 28 coupled to the single integrated-circuit (IC) chip 30. Referring to Fig. 1B, the single integrated-circuit (IC) chip 28 has a set of four amplifiers 17, such as single-ended-to-differential amplifiers, arranged in parallel. A topmost one of the four amplifiers 17 may have a single-ended input coupled to the output of a topmost one of the mixers 15. A second top one of the four amplifiers 17 may have a single-ended input coupled to the output of a second top one of the mixers 15. A second bottom one of the four amplifiers 17 may have a single-ended input coupled to the output of a second bottom one of the mixers 15. A bottommost one of the four amplifiers 17 may have a single-ended input coupled to the output of a bottommost one of the mixers 15. Each of the four amplifiers 17 may amplify its single-ended input into its differential output with a phase difference of substantially 180 degrees.

Referring to Figs. 1A and 1B, the single integrated-circuit (IC) chip 28 may include a switch matrix 18 having four differential inputs each coupled to the differential output of one of the four amplifiers 17. The switch matrix 18 may be controlled to switch one of its four differential inputs each having a phase difference of substantially 180 degrees to one or more of its six differential outputs each having a phase difference of substantially 180 degrees. The bottom two of the six differential outputs of the switch matrix 18 may be provided respectively as two outputs of the single integrated-circuit (IC) chip 28 to be coupled respectively to two legacy ports of the signal receiver 10 for supporting older hardware connections.

Referring to Figs. 1A and 1B, the single integrated-circuit (IC) chip 28 may include a set of four amplifiers 19, such as differential-to-differential amplifiers, arranged in parallel. Each of the four amplifiers 19 may have a differential input coupled to one of the top four of the six differential outputs of the switch matrix 18. Each of the amplifiers 19 may amplify its differential input having a phase difference of substantially 180 degrees into its differential output.

Referring to Figs. 1A and 1B, the single integrated-circuit (IC) chip 28 may include a set of four synthesizers 20, i.e., local oscillators (LO), each having an oscillating output and a set of four mixers 21 arranged in parallel. Each of the four mixers 21 may have its first input, such as differential input, coupled to the differential output of one of the four amplifiers 19 and its second input coupled to the oscillating output of one of the four synthesizers 20 and mix its first and second inputs into an output such as differential output.

Referring to Figs. 1A and 1B, the single integrated-circuit (IC) chip 28 may include a set of four amplifiers 22, such as differential-to-differential amplifiers, arranged in parallel. Each of the four amplifiers 22 may have a differential input coupled to the differential output of one of the mixers 21. Each of the amplifiers 22 may amplify its differential input into a differential output.

Referring to Figs. 1A and 1B, the single integrated-circuit (IC) chip 28 may include a set of four image rejection filters 23 arranged in parallel. Each of the four image rejection filters 23 may have differential input coupled to the differential output of one of the amplifiers 22. Each of the image rejection filters 23 may suppress image components of its differential input into a differential output.

Referring to Figs. 1A and 1B, the single integrated-circuit (IC) chip 28 may include a set of four synthesizers 24, i.e., local oscillators (LO), each having an oscillating output and a set of four mixers 25 arranged in parallel. Each of the four mixers 25 may have its first input, such as differential input, coupled to the differential output of one of the four image rejection filters 23 and its second input coupled to the oscillating output of one of the four synthesizers 24 and mix its first and second inputs into a differential output.

Referring to Figs. 1A and 1B, the single integrated-circuit (IC) chip 28 may include a set of four amplifiers 70, such as differential-to-single-ended amplifiers, arranged in parallel. Each of the four amplifiers 70 may have a differential input coupled to one of the four differential outputs of the mixers 25. Each of the amplifiers 70 may amplify its differential input having a phase difference of substantially 180 degrees into a single-ended output and have an optimum 1dB compression point (P1dB) to prevent electronic devices downstream of said each of the amplifiers 70 from being burned out when an excessive power flows through said each of the amplifiers 70.

Referring to Figs. 1A and 1B, the single integrated-circuit (IC) chip 28 may include an optimization unit 27 coupled to the synthesizers 20 and 24. The optimization unit 27 may compare the frequencies of each two of the oscillating outputs of the eight synthesizers 20 and 24 so as to generate a comparison result. When the optimization unit 27 determines the oscillating outputs of two of the eight synthesizers 20 and 24 have an identical frequency or similar frequencies with a difference in a specific range of less than 0.5 MHz and preferably less than 0.25 MHz, for example, in accordance with the comparison result, the optimization unit 27 may adjust a first one of said two of the eight synthesizers 20 and 24 to shift a frequency of its oscillating output with a first certain frequency and adjust a second one of the synthesizers 20 and 24, having its oscillating output mixed into the same signal path as the oscillating output of the first one of said two of the synthesizers 20 and 24 is mixed, to shift a frequency of its oscillating output with a second certain frequency such that the frequencies of the oscillating outputs of each two of the synthesizers 20 and 24 may be adjusted to be different from each other. The first and second certain frequencies may have substantially the same levels in the opposite directions. For example, when the oscillating output of a topmost one of the synthesizers 20 is adjusted by the optimization unit 27 to be shifted with a frequency of +1.0 MHz, a topmost one of the synthesizers 24 may be adjusted by the optimization units 27 to be shifted with a frequency of -1.0 MHz.

Referring to Figs. 1A and 1B, the single integrated-circuit (IC) chip 28 may include a combiner 26 that may have its four inputs each coupled to the single-ended output of one of the four amplifiers 70 and combine its four inputs into an output as an output of the single integrated-circuit (IC) chip 28.

Accordingly, referring to Figs. 1A and 1B, the set of four amplifiers 17, the switch matrix 18, the set of four amplifiers 19, the set of four synthesizers 20, the set of four mixers 21, the set of four amplifiers 22, the set of four image rejection filters 23, the set of four synthesizers 24, the set of four mixers 25, the set of four amplifiers 70, the combiner 26 and the optimization unit 27 may be incorporated in the single integrated-circuit (IC) chip 28.

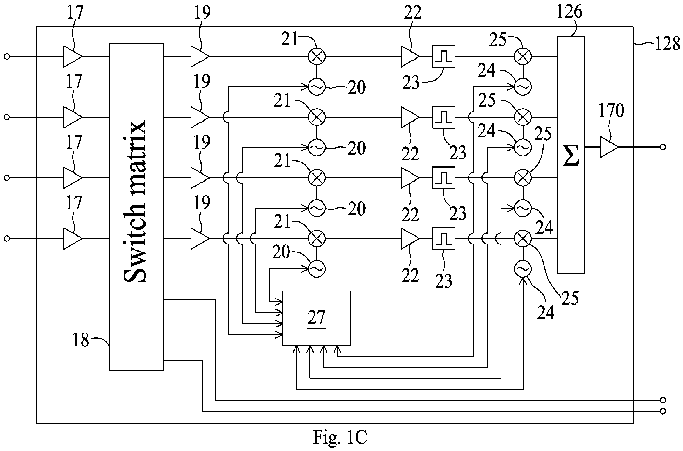

Alternatively, Fig. 1C is a block diagram illustrating another type of single integrated-circuit (IC) chip in accordance with a first embodiment of the present invention. Referring to Figs. 1A and 1C, the signal receiver 10 may include a second combination of two single integrated-circuit (IC) chips 128 having the same circuit scheme. The single integrated-circuit (IC) chip 128 is similar to the single integrated-circuit (IC) chip 28 as illustrated in Fig. 1B except for the following description. The same reference number illustrated in Figs. 1B and 1C indicates elements having the same functions. Referring to Fig. 1C, the single integrated-circuit (IC) chip 128 may include a combiner 126 that may have its four differential inputs each coupled to one of the four differential outputs of the mixers 25 and combine its four differential inputs into a differential output. The two single integrated-circuit (IC) chip 128 may include an amplifier 170, such as differential-to-single-ended amplifier. The amplifier 170 may have a differential input coupled to the differential output of the combiner 126. The amplifier 170 may amplify its differential input having a phase difference of substantially 180 degrees into a single-ended output and have an optimum 1dB compression point (P1dB) to prevent electronic devices downstream of the amplifier 170 from being burned out when an excessive power flows through the amplifier 170.

Accordingly, referring to Fig. 1C, the set of four amplifiers 17, the switch matrix 18, the set of four amplifiers 19, the set of four synthesizers 20, the set of four mixers 21, the set of four amplifiers 22, the set of four image rejection filters 23, the set of four synthesizers 24, the set of four mixers 25, the optimization unit 27, the combiner 126 and the amplifier 170 may be incorporated in the single integrated-circuit (IC) chip 128.

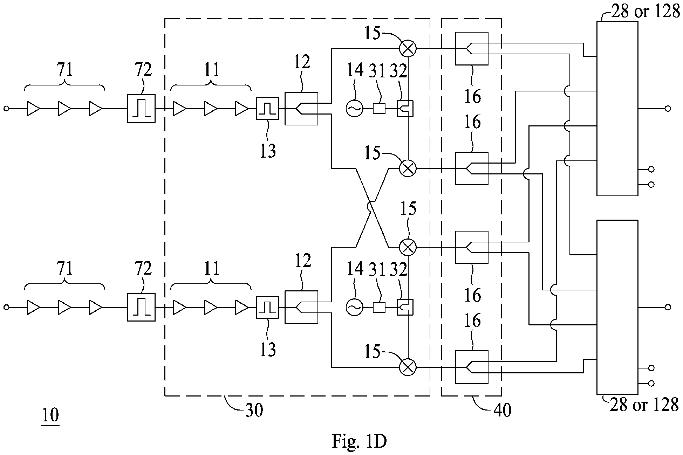

Alternatively, Fig. 1D illustrates a block diagram of another signal receiver in accordance with the first embodiment of the present invention. The same reference number illustrated in Figs. 1A, 1B, 1C and 1D indicates elements having the same functions. Referring to Fig. 1D, the signal receiver 10 may include a splitter matrix 40 having four splitters 16, i.e. power dividers, arranged in parallel, wherein a topmost one of the four splitters 16 may have its input coupled to the output of the topmost one of the mixers 15, a second top one of the four splitters 16 may have its input coupled to the output of the second top one of the mixers 15, a second bottom one of the four splitters 16 may have its input coupled to the output of the second bottom one of the mixers 15 and a bottommost one of the four splitters 16 may have its input coupled to the output of the bottommost one of the mixers 15. Each of the four splitters 16 may split its input into two identities with substantially the same power at two respective outputs of said each of the splitters 16.

Further, referring to Figs. 1A, 1B and 1D, the signal receiver 10 may include a first combination of two single integrated-circuit (IC) chips 28 as seen in Fig. 1B coupled to the single integrated-circuit (IC) chip 30 through the splitter matrix 40. A topmost one of the four amplifiers 17 in each of the two single integrated-circuit (IC) chips 28 may have a single-ended input coupled to one of the outputs of a topmost one of the splitters 16. A second top one of the four amplifiers 17 in each of the two single integrated-circuit (IC) chips 28 may have a single-ended input coupled to one of the outputs of a second top one of the splitters 16. A second bottom one of the four amplifiers 17 in each of the two single integrated-circuit (IC) chips 28 may have a single-ended input coupled to one of the outputs of a second bottom one of the splitters 16. A bottommost one of the four amplifiers 17 in each of the two single integrated-circuit (IC) chips 28 may have a single-ended input coupled to one of the outputs of a bottommost one of the splitters 16.

Alternatively, referring to Figs. 1A, 1B, 1C and 1D, the signal receiver 10 may include a second combination of two single integrated-circuit (IC) chips 128 as seen in Fig. 1C coupled to the single integrated-circuit (IC) chip 30 through the splitter matrix 40. A topmost one of the four amplifiers 17 in each of the two single integrated-circuit (IC) chips 128 may have a single-ended input coupled to one of the outputs of a topmost one of the splitters 16. A second top one of the four amplifiers 17 in each of the two single integrated-circuit (IC) chips 128 may have a single-ended input coupled to one of the outputs of a second top one of the splitters 16. A second bottom one of the four amplifiers 17 in each of the two single integrated-circuit (IC) chips 128 may have a single-ended input coupled to one of the outputs of a second bottom one of the splitters 16. A bottommost one of the four amplifiers 17 in each of the two single integrated-circuit (IC) chips 128 may have a single-ended input coupled to one of the outputs of a bottommost one of the splitters 16.

Alternatively, referring to Figs. 1A, 1B, 1C and 1D, the signal receiver 10 may include a third combination of the two single integrated-circuit (IC) chips 28 and 128 having different circuit schemes. For example, the single integrated-circuit (IC) chip 28 as seen in Fig. 1B may include the set of four amplifiers 17 each having its input coupled to a top one of the two outputs of one of the four splitters 16, and the single integrated-circuit (IC) chip 128 as seen in Fig. 1C may include the set of four amplifiers 17 each having its input coupled to a bottom one of the two outputs of one of the splitters 16.

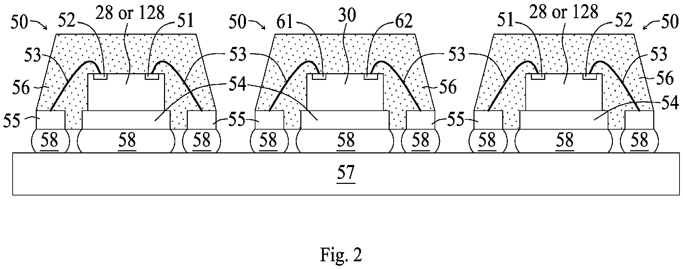

Fig. 2 illustrates packages for multiple single integrated-circuit (IC) chips in accordance with the first embodiment of the present application. Referring to Figs. 1A, 1B, 1C, 1D and 2, each of the single integrated-circuit (IC) chips 28 and/or 128 and the single integrated-circuit (IC) chip 30 may be packaged into a quad flat no-lead (QFN) package 50 mentioned as below. Each of the single integrated-circuit (IC) chips 28 and/or 128 may have four input metal pads 51 (only one is shown) each coupled to the single-ended input of one of its four amplifiers 17 and an output metal pad 52 coupled to the output of its combiner 26 as shown in Fig. 1B for the single integrated-circuit (IC) chip 28 or to the output of its amplifier 170 as shown in Fig. 1C for the single integrated-circuit (IC) chip 128. The input and output metal pads 51 and 52 may be made of aluminum or cupper at a front side of said each of the single integrated-circuit (IC) chips 28 and/or 128. The single integrated-circuit (IC) chip 30 may have two input metal pads 61 (only one is shown) each coupled to the first stage of amplifier 11 in one of the two sets and four output metal pads 62 each coupled to the output of one of the mixers 15. The input and output metal pads 61 and 62 may be made of aluminum or cupper at a front side of the single integrated-circuit (IC) chip 30. Each of the three quad flat no-lead (QFN) packages 50 includes one of the single integrated-circuit (IC) chips 30, 28 and 128, a die pad 54 having said one of the single integrated-circuit (IC) chips 30, 28 and 128 mounted to a front side thereof and multiple metal pads 55 surrounding the die pad 54 in a plane, multiple wires 53 made of gold or cupper each having an end wirebonded to a front side of one of the metal pads 55 and the other end wirebonded to one of the metal pads 51, 52, 61 and 62 of said one of the single integrated-circuit (IC) chips 30, 28 and 128 and a polymer compound 56 encapsulating the wires 53, the metal pads 55 and said one of the single integrated-circuit (IC) chips 30, 28 and 128.

Referring to Figs. 1A, 1B, 1C, 1D and 2, a carrier 57, such as printed circuit board or ceramic substrate, may be provided to have the three quad flat no-lead (QFN) packages 50 mounted thereto via a tin-containing solder 58. The tin-containing solder 58 may join back sides of the die pads 54 to the carrier 57 and join back sides of the metal pads 55 to the carrier 57. The four splitters 16 in the splitter matrix 40 may be incorporated into another single integrated-circuit (IC) chip (not shown), which may be packaged to be mounted to the carrier 57, or may be discretely mounted to the carrier 57.

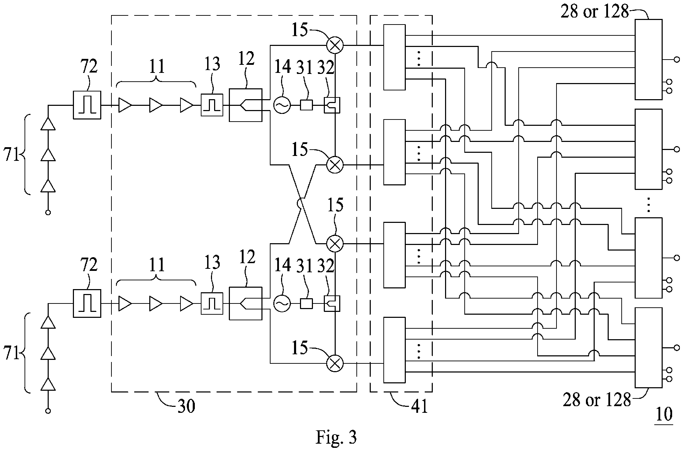

Fig. 3 illustrates a block diagram of a signal receiver in accordance with the first embodiment of the present invention. The same reference number illustrated in Figs. 1A, 1B, 1C, 1D and 3 indicates elements having the same functions. In Fig. 1D, the output of each of the mixers 15 in the single integrated-circuit chip 30 is split by the splitter matrix 40 into two identities with substantially the same power. Alternatively, referring to Fig. 3, the output of each of the mixers 15 in the single integrated-circuit chip 30 may be split by another splitter matrix 41 into any number of identities, such as four ones, with substantially the same power. The number of a fourth combination of the single integrated-circuit (IC) chips 28 and 128, such as four ones, may be provided each including the four amplifiers 17 having four respective inputs associated with the outputs of the four respective mixers 15 via connection of the splitter matrix 41. The fourth combination may include a single type of the single integrated-circuit (IC) chips 28, each of which is provided with the combiner 26 configured to generate its output as an output of said each of the single integrated-circuit (IC) chips 28. Alternatively, the fourth combination may include a single type of the single integrated-circuit (IC) chips 128, each of which is provided with the amplifier 170 configured to generate its output as an output of said each of the single integrated-circuit (IC) chips 128. Alternatively, the fourth combination may include one or more of the single integrated-circuit (IC) chips 28 that is provided with the combiner 26 configured to generate its output as an output of said one or more of the single integrated-circuit (IC) chips 28 and one or more of the single integrated-circuit (IC) chips 128 that is provided with the amplifier 170 configured to generate its output as an output of said one or more of the single integrated-circuit (IC) chips 128.

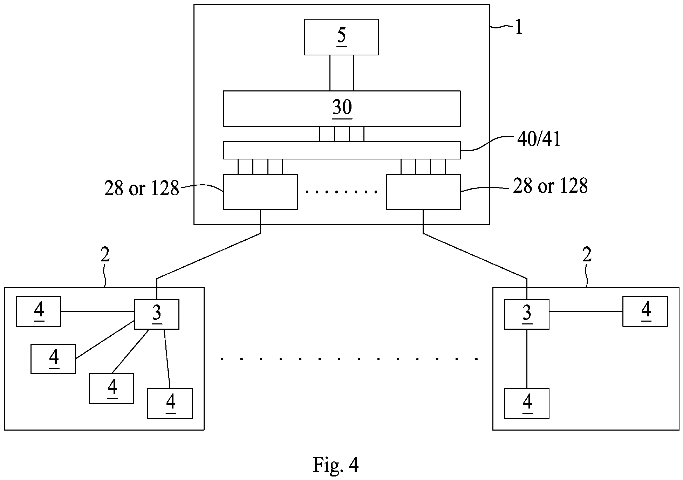

Fig. 4 illustrates a block diagram of a signal receiver set in an outdoor unit to work with multiple indoor units in accordance with the first embodiment of the present invention. Referring to Fig. 4, the signal receiver as illustrated in Figs. 1A, 1B, 1C, 1D or 3 may be set in an outdoor unit 1 to have the two sets of multi-stage amplifiers 11 in the single integrated-circuit chip 30 with their two inputs associated respectively with vertically and horizontally polarized signals collected by an antenna feed horn 5 of the outdoor unit 1 or associated respectively with left-hand and right-hand circularly polarized signals collected by the antenna feed horn 5 of the outdoor unit 1. The combiner 26 incorporated in each of the single integrated-circuit (IC) chips 28 or the amplifier 170 incorporated in each of the single integrated-circuit (IC) chips 128 may generate its output as an output of the outdoor unit 1 to be coupled to one of indoor units 2. Each of the indoor units 2 may include a splitter 3, i.e. power divider, to split its input associated with the output of the combiner 26 incorporated in one of the single integrated-circuit (IC) chips 28 or the output of the amplifier 170 incorporated in one of the single integrated-circuit (IC) chips 128 into multiple identities with substantially the same power at multiple respective outputs of the splitter 3 and multiple setup boxes 4 each having an input coupled to one of the outputs of the splitter 3 to demodulate its input into an output. Alternatively, if one of the indoor units 2 has only one setup box 4, the splitter 3 may be omitted in said one of the indoor units 2 and the only one setup box 4 has an input associated with an output of the combiner 26 incorporated in one of the single integrated-circuit (IC) chips 28 or an output of the amplifier 170 incorporated in one of the single integrated-circuit (IC) chips 128.

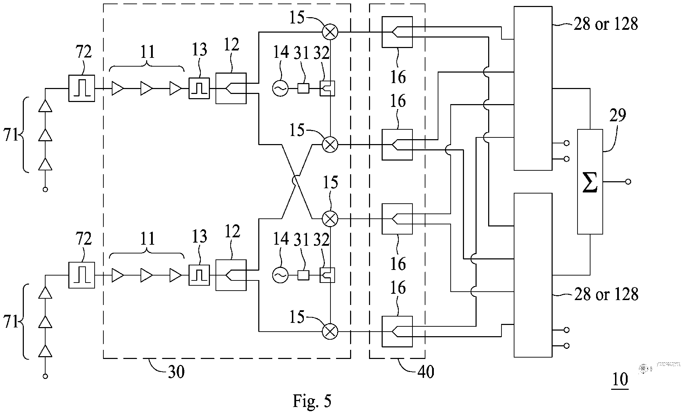

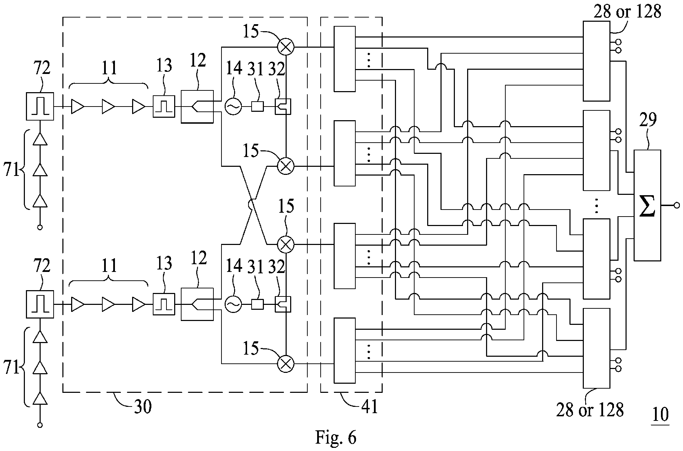

Fig. 5 illustrates a block diagram of a signal receiver in accordance with the first embodiment of the present invention. Fig. 6 illustrates a block diagram of a signal receiver in accordance with the first embodiment of the present invention. The same reference number illustrated in Figs. 1A, 1B, 1C, 1D, 3, 5 and 6 indicates elements having the same functions. Referring to Fig. 5, the signal receiver 10 may further include a combiner 29 having its multiple inputs each coupled to the output of one of the combiners 26 of the single integrated-circuit (IC) chips 28 in the first, second or third combination or the output of one of the amplifiers 170 of the single integrated-circuit (IC) chips 128 in the first, second and third combination and combine its multiple inputs into an output. Referring to Fig. 6, the signal receiver 10 may further include a combiner 29 having its multiple inputs each coupled to the output of one of the combiners 26 of the single integrated-circuit (IC) chips 28 in the fourth combination or the output of one of the amplifiers 170 of the single integrated-circuit (IC) chips 128 in the fourth combination and combine its multiple inputs into an output.

### Second Embodiment

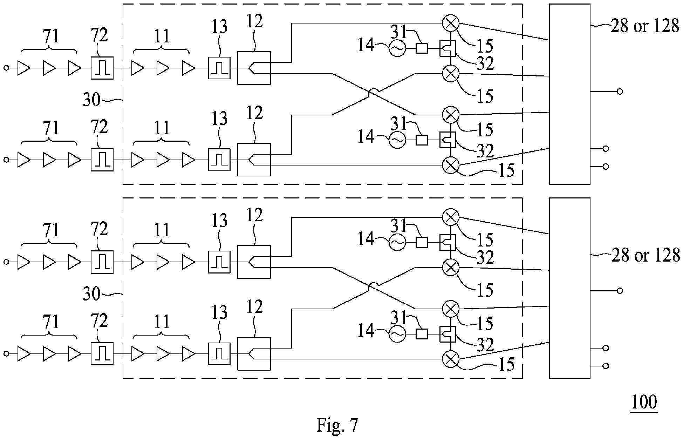

Fig. 7 illustrates a block diagram of a signal receiver in accordance with a second embodiment of the present invention. The same reference number illustrated in Figs. 1A and 7 indicates elements having the same functions. Alternatively, the single integrated-circuit chip 30 illustrated in Fig. 1A may be doubled to be arranged in parallel to work with a fifth combination of the two single integrated-circuit (IC) chips 28 and/or 128 arranged in parallel respectively. The fifth combination may include the two single integrated-circuit (IC) chips 28 arranged in parallel to each other and with the same circuit structure as the single integrated-circuit (IC) chip 28 as shown in Fig. 1B. Alternatively, the fifth combination may include the two single integrated-circuit (IC) chips 128 arranged in parallel to each other and with the same circuit structure as the single integrated-circuit (IC) chip 128 as shown in Fig. 1C. Alternatively, the fifth combination may include the single integrated-circuit (IC) chips 28 and 128 arranged in parallel to each other. Referring to Fig. 7, with regard to the second embodiment, a signal receiver 100 is provided with the two single integrated-circuit chips 30 coupled in series to the fifth combination of the two single integrated-circuit (IC) chips 28 and/or 128 respectively. Each of the two single integrated-circuit chips 30 may process vertically and horizontally polarized signals or right-hand and left-hand circularly polarized signals, collected by one of antenna feed horns of the signal receiver 10 at a focal point of an antenna dish or reflector dish of the outdoor unit, from multiple satellites in a field of view of the signal receiver 100. For example, a vertically polarized signal collected from one of the antenna feed horns may be transmitted to the input of a top one of the two sets of multi-stage amplifiers 11 in a top one of the single integrated-circuit chips 30, and a horizontally polarized signal collected from said one of the antenna feed horns may be transmitted to the input of a bottom one of the two sets of multi-stage amplifiers 11 in the top one of the single integrated-circuit chips 30; another vertically polarized signal collected from another one of the antenna feed horns may be transmitted to the input of a top one of the two sets of multi-stage amplifiers 11 in a bottom one of the single integrated-circuit chips 30, and another horizontally polarized signal collected from said another one of the antenna feed horns may be transmitted to the input of a bottom one of the two sets of multi-stage amplifiers 11 in the bottom one of the single integrated-circuit chips 30. Alternatively, a left-hand circularly polarized signal collected from one of the antenna feed horns may be transmitted to the input of a top one of the two sets of multi-stage amplifiers 11 in a top one of the single integrated-circuit chips 30, and a right-hand circularly polarized signal collected from said one of the antenna feed horns may be transmitted to the input of a bottom one of the two sets of multi-stage amplifiers 11 in the top one of the single integrated-circuit chips 30; another left-hand circularly polarized signal collected from another one of the antenna feed horns may be transmitted to the input of a top one of the two sets of multi-stage amplifiers 11 in a bottom one of the single integrated-circuit chips 30, and another right-hand circularly polarized signal collected from said another one of the antenna feed horns may be transmitted to the input of a bottom one of the two sets of multi-stage amplifiers 11 in the bottom one of the single integrated-circuit chips 30. Alternatively, a vertically polarized signal collected from one of the antenna feed horns may be transmitted to the input of a top one of the two sets of multi-stage amplifiers 11 in a top one of the single integrated-circuit chips 30, and a horizontally polarized signal collected from said one of the antenna feed horns may be transmitted to the input of a bottom one of the two sets of multi-stage amplifiers 11 in the top one of the single integrated-circuit chips 30; a left-hand circularly polarized signal collected from another one of the antenna feed horns may be transmitted to the input of a top one of the two sets of multi-stage amplifiers 11 in a bottom one of the single integrated-circuit chips 30, and a right-hand circularly polarized signal collected from said another one of the antenna feed horns may be transmitted to the input of a bottom one of the two sets of multi-stage amplifiers 11 in the bottom one of the single integrated-circuit chips 30.

Referring to Figs. 1B, 1C and 7, each of the four amplifiers 17 in a top one of the single integrated-circuit (IC) chips 28 and/or 128 in the fifth combination may have its single-ended input coupled to the output of one of the four mixers 15 in a top one of the two single integrated-circuit chips 30, and each of the four amplifiers 17 in a bottom one of the single integrated-circuit (IC) chips 28 and/or 128 in the fifth combination may have its single-ended input coupled to the output of one of the four mixers 15 in a bottom one of the two single integrated-circuit chips 30.

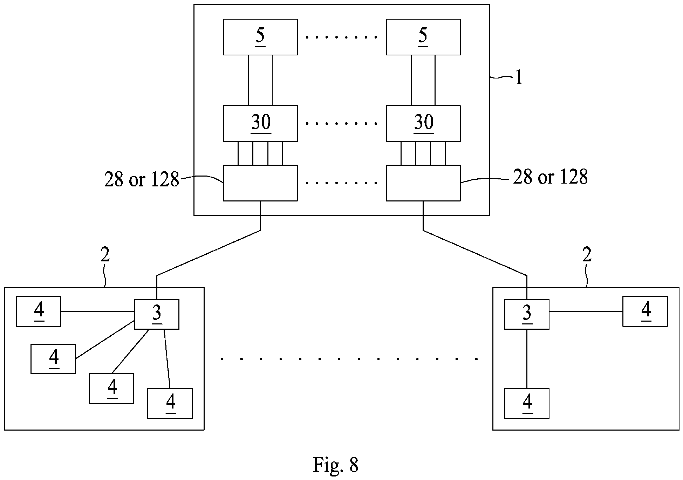

Fig. 8 illustrates a block diagram of a signal receiver set in an outdoor unit to work with multiple indoor units in accordance with the second embodiment of the present invention. Referring to Fig. 8, the outdoor unit may include the single integrated-circuit chips 30 arranged in parallel with the number greater than or equal to two, such as four, and a sixth combination of the single integrated-circuit (IC) chips 28 and/or 128 arranged in parallel with the number greater than or equal to two, such as four, wherein the single integrated-circuit chips 30 may be coupled in series to the sixth combination of the single integrated-circuit (IC) chips 28 and 128 respectively. The sixth combination may include a single type of the single integrated-circuit (IC) chips 28 as seen in Fig. 1B, each of which is provided with the combiner 26 configured to generate its output as an output of said each of the single integrated-circuit (IC) chips 28. Alternatively, the sixth combination may include a single type of the single integrated-circuit (IC) chips 128 as seen in Fig. 1C, each of which is provided with the amplifier 170 configured to generate its output as an output of said each of the single integrated-circuit (IC) chips 128. Alternatively, the sixth combination may include one or more of the single integrated-circuit (IC) chips 28 as seen in Fig. 1B that is provided with the combiner 26 configured to generate its output as an output of said one or more of the single integrated-circuit (IC) chips 28 and one or more of the single integrated-circuit (IC) chips 128 as seen in Fig. 1C that is provided with the amplifier 170 configured to generate its output as an output of said one or more of the single integrated-circuit (IC) chips 128. Each of the single integrated-circuit chips 30 may have the two sets of multi-stage amplifiers 11 to process vertically and horizontally polarized signals respectively or right-hand and left-hand circularly polarized signals respectively, collected by one of antenna feed horns 5 of the signal receiver 10 at a focal point of an antenna dish or reflector dish of the outdoor unit, from multiple satellites in a field of view of the signal receiver 100. Each of the indoor units 2 may include a splitter 3, i.e. power divider, to split its input associated with the output of the combiner 26 incorporated in one of the single integrated-circuit (IC) chips 28 or the output of the amplifier 170 incorporated in one of the single integrated-circuit (IC) chips 128 into multiple identities with substantially the same power at multiple respective outputs of the splitter 3 and multiple setup boxes 4 each having an input coupled to one of the outputs of the splitter 3 to demodulate its input into an output. Alternatively, if one of the indoor units 2 has only one setup box 4, the splitter 3 may be omitted in said one of the indoor units 2 and the only one setup box 4 has an input associated with the output of the combiner 26 incorporated in one of the single integrated-circuit (IC) chips 28 or the output of the amplifier 170 incorporated in one of the single integrated-circuit (IC) chips 128.

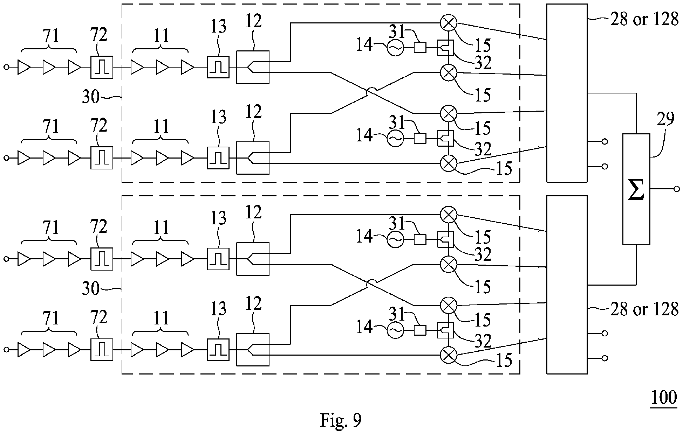

Fig. 9 illustrates a block diagram of a signal receiver in accordance with the second embodiment of the present invention. The same reference number illustrated in Figs. 1A, 1B,1C, 7 and 9 indicates elements having the same functions. Referring to Fig. 9, the signal receiver 100 may further include a combiner 29 having its multiple inputs each coupled to the output of one of the combiners 26 of the single integrated-circuit (IC) chips 28 in the fifth combination or the output of one of the amplifiers 170 of the single integrated-circuit (IC) chips 128 in the fifth combination and combine its multiple inputs into an output.

### Third Embodiment

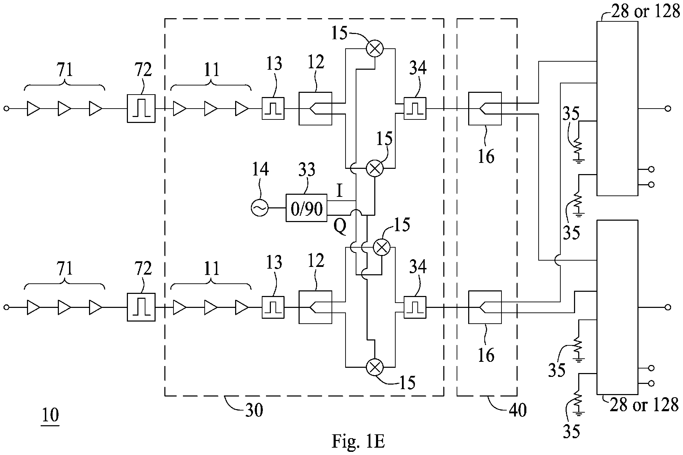

Fig. 1E illustrates a block diagram of a signal receiver in accordance with a third embodiment of the present invention. Alternatively, the single integrated circuit chip 30 illustrated in Fig. 1A or 1D may be replaced with another single integrated circuit chip 300, as seen in Fig. 1E. The same reference number illustrated in Figs. 1A-1E indicates elements having the same functions. Referring to Fig. 1E, a signal receiver 200 may include a splitter 33, such as in-phase/quadrature (I/Q) splitter, that may have its input coupled to the oscillating output of the synthesizer 14 and split its input associated with the oscillating output of the synthesizer 14 into a pair of oscillating outputs with phase difference of 90 degrees, e.g., in-phase (I) and quadrature (Q) clock signals.

Referring to Fig. 1E, the topmost one of the four mixers 15 may have its first input coupled to the top one of the two outputs of the top one of the two splitters 12 and its second input coupled to a top one of the pair of outputs of the in-phase/quadrature (I/Q) splitter 33 and mix its first and second inputs into an output. The second top one of the four mixers 15 may have its first input coupled to the bottom one of the two outputs of the top one of the two splitters 12 and its second input coupled to a bottom one of the pair of outputs of the in-phase/quadrature (I/Q) splitter 33 and mix its first and second inputs into an output. The second bottom one of the four mixers 15 may have its first input coupled to the top one of the two outputs of the bottom one of the two splitters 12 and its second input coupled to the top one of the pair of outputs of the in-phase/quadrature (I/Q) splitter 33 and mix its first and second inputs into an output. The bottommost one of the four mixers 15 may have its first input coupled to the bottom one of the two outputs of the bottom one of the two splitters 12 and its second input coupled to the bottom one of the pair of outputs of the in-phase/quadrature (I/Q) splitter 33 and mix its first and second inputs into an output.

Referring to Fig. 1E, the signal receiver 200 may include two image rejection filters 34 arranged in parallel, wherein a top one of the two image rejection filters 34 having its two inputs respectively coupled to the outputs of the top two of the mixers 15 may be configured to attenuate an image part of one of its two inputs and pass a real part of said one of its two inputs into a first image rejected signals, to attenuate an image part of the other one of its two inputs and pass a real part of the other one of its two inputs into a second image rejected signal and then to shift a phase or phases of one or both of the first and second image rejected signals to be in phase with each other and to be combined into an output of the top one of the image rejection filters 34; a bottom one of the combiners 34 having its two inputs respectively coupled to the outputs of the bottom two of the mixers 15 may be configured to attenuate an image part of one of its two inputs and pass a real part of said one of its two inputs into a third image rejected signals, to attenuate an image part of the other one of its two inputs and pass a real part of the other one of its two inputs into a fourth image rejected signal and then to shift a phase or phases of one or both of the third and fourth image rejected signals to be in phase with each other and to be combined into an output of the bottom one of the image rejection filters 34. The two sets of multi-stage amplifiers 11, two splitters 12, two band-pass filters (BPF) 13, synthesizer 14, in-phase/quadrature (I/Q) splitter 33, four mixers 15 and two image rejection filters 34 may compose a radio-frequency (RF) module incorporated in the single integrated circuit chip 300.

Alternatively, referring to Fig. 1E, the splitter matrix 40 may have the splitters 16, i.e. power dividers, arranged in parallel and with the number of two, wherein the top one of the two splitters 16 may have its input coupled to the output of a top one of the image rejection filters 34 and a bottome one of the two splitters 16 may have its input coupled to the output of the bottom one of the image rejection filters 34. Each of the two splitters 16 may split its input into two identities with substantially the same power at two respective outputs of said each of the splitters 16.Further, referring to Figs. 1B and 1E, the signal receiver 200 may include a seventh combination of two single integrated-circuit (IC) chips 28 as seen in Fig. 1B coupled to the single integrated-circuit (IC) chip 300 through the splitter matrix 40. A topmost one of the four amplifiers 17 in each of the two single integrated-circuit (IC) chips 28 may have a single-ended input coupled to one of the outputs of a top one of the splitters 16. A second top one of the four amplifiers 17 in each of the two single integrated-circuit (IC) chips 28 may have a single-ended input coupled to one of the outputs of a bottom one of the splitters 16. A second bottom one of the four amplifiers 17 in each of the two single integrated-circuit (IC) chips 28 may have a single-ended input coupled to the ground reference through a resistor 35 having resistance between 10 and 100 ohms for example. A bottommost one of the four amplifiers 17 in each of the two single integrated-circuit (IC) chips 28 may have a single-ended input coupled to the ground reference through a resistor 35 having resistance between 10 and 100 ohms for example.

Alternatively, referring to Figs. 1C and 1E, the signal receiver 200 may include an eighth combination of two single integrated-circuit (IC) chips 128 as seen in Fig. 1C coupled to the single integrated-circuit (IC) chip 300 through the splitter matrix 40. A topmost one of the four amplifiers 17 in each of the two single integrated-circuit (IC) chips 128 may have a single-ended input coupled to one of the outputs of a top one of the splitters 16. A second top one of the four amplifiers 17 in each of the two single integrated-circuit (IC) chips 128 may have a single-ended input coupled to one of the outputs of a bottom one of the splitters 16. A second bottom one of the four amplifiers 17 in each of the two single integrated-circuit (IC) chips 128 may have a single-ended input coupled to the ground reference through a resistor 35 having resistance between 10 and 100 ohms for example. A bottommost one of the four amplifiers 17 in each of the two single integrated-circuit (IC) chips 128 may have a single-ended input coupled to the ground reference through a resistor 35 having resistance between 10 and 100 ohms for example.

Alternatively, referring to Figs. 1B, 1C and 1E, the signal receiver 200 may include a ninth combination of the two single integrated-circuit (IC) chips 28 and 128 having different circuit schemes. For example, the single integrated-circuit (IC) chip 28 as seen in Fig. 1B may include the set of four amplifiers 17 each having its input coupled to a top one of the two outputs of one of the four splitters 16, and the single integrated-circuit (IC) chip 128 as seen in Fig. 1C may include the set of four amplifiers 17 each having its input coupled to a bottom one of the two outputs of one of the splitters 16.

The components, steps, features, benefits and advantages that have been discussed are merely illustrative. None of them, nor the discussions relating to them, are intended to limit the scope of protection in any way. Numerous other embodiments are also contemplated. These include embodiments that have fewer, additional, and/or different components, steps, features, benefits and advantages. These also include embodiments in which the components and/or steps are arranged and/or ordered differently.

Unless otherwise stated, all measurements, values, ratings, positions, magnitudes, sizes, and other specifications that are set forth in this specification, including in the claims that follow, are approximate, not exact. They are intended to have a reasonable range that is consistent with the functions to which they relate and with what is customary in the art to which they pertain. Furthermore, unless stated otherwise, the numerical ranges provided are intended to be inclusive of the stated lower and upper values. Moreover, unless stated otherwise, all material selections and numerical values are representative of preferred embodiments and other ranges and/or materials may be used.

The scope of protection is limited solely by the claims, and such scope is intended and should be interpreted to be as broad as is consistent with the ordinary meaning of the language that is used in the claims when interpreted in light of this specification and the prosecution history that follows, and to encompass all structural and functional equivalents thereof.

## Claims

1. A signal receiver comprising:
a first amplifier configured to amplify its input into an output;
a first splitter configured to split its input associated with said output of said first amplifier into a first output and a second output;
a second amplifier configured to amplify its input into an output.
a second splitter configured to split its input associated with said output of said second amplifier into a first output and a second output;
a first synthesizer configured to generate a first oscillating output having a first frequency;
a first frequency multiplier configured to multiply said first oscillating output into a second oscillating output having a second frequency greater than said first frequency;
a first mixer configured to mix its first input associated with said first output of said first splitter with its second input associated with said second oscillating output of said first frequency multiplier into an output;
a second mixer configured to mix its first input associated with said first output of said second splitter with its second input associated with said second oscillating output of said first frequency multiplier into an output;
a second synthesizer configured to generate a third oscillating output having a third frequency;
a second frequency multiplier configured to multiply said third oscillating output into a fourth oscillating output having a fourth frequency greater than said third frequency;
a third mixer configured to mix its first input associated with said second output of said first splitter with its second input associated with said fourth oscillating output of said second frequency multiplier into an output; and
a fourth mixer configured to mix its first input associated with said second output of said second splitter with its second input associated with said fourth oscillating output of said second frequency multiplier into an output, wherein said first and second amplifiers, first and second splitters, first and second synthesizers, first and second frequency multipliers and first, second, third and fourth mixers are incorporated in a single integrated-circuit (IC) chip.

2. The signal receiver of claim 1 further comprising a third amplifier configured to amplify its input into an output, wherein said input of said first amplifier is associated with said output of said third amplifier, wherein said first, second and third amplifiers, first and second splitters, first and second synthesizers, first and second frequency multipliers and first, second, third and fourth mixers are incorporated in said single integrated-circuit (IC) chip.

3. The signal receiver of claim 2 further comprising a fourth amplifier configured to amplify its input into an output, wherein said input of said second amplifier is associated with said output of said fourth amplifier, wherein said first, second, third and fourth amplifiers, first and second splitters, first and second synthesizers, first and second frequency multipliers and first, second, third and fourth mixers are incorporated in said single integrated-circuit (IC) chip.

4. The signal receiver of claim 1 further comprising a first band-pass filter configured to pass its input, associated with said output of said first amplifier, at frequencies within a first frequency range and attenuate said its input at frequencies outside said first frequency range as an output, wherein said input of said first splitter is associated with said output of said first band-pass filter, wherein said first and second amplifiers, first band-pass filter, first and second splitters, first and second synthesizers, first and second frequency multipliers and first, second, third and fourth mixers are incorporated in said single integrated-circuit (IC) chip.

5. The signal receiver of claim 4 further comprising a second band-pass filter configured to pass its input, associated with said output of said second amplifier, at frequencies within a second frequency range and attenuate said its input at frequencies outside said second frequency range as an output, wherein said input of said second splitter is associated with said output of said second band-pass filter, wherein said first and second amplifiers, first and second band-pass filters, first and second splitters, first and second synthesizers, first and second frequency multipliers and first, second, third and fourth mixers are incorporated in said single integrated-circuit (IC) chip.

6. The signal receiver of claim 1, wherein said fourth frequency is greater than said second frequency.

7. The signal receiver of claim 1, wherein said third frequency is greater than said first frequency.

8. The signal receiver of claim 1, wherein said second frequency is equal to two times of said first frequency.

9. The signal receiver of claim 8, wherein said fourth frequency is equal to two times of said third frequency.

10. The signal receiver of claim 1, wherein said first frequency is between 4.0 GHz and 6.0 GHz.

11. The signal receiver of claim 10, wherein said third frequency is between 4.0 GHz and 6.0 GHz.

12. The signal receiver of claim 1, wherein said first frequency is between 8.0 GHz and 12.0 GHz.

13. The signal receiver of claim 12, wherein said third frequency is between 8.0 GHz and 12.0 GHz.

14. The signal receiver of claim 1, wherein said first and second outputs of said first splitter have substantially the same power.

15. The signal receiver of claim 14, wherein said first and second outputs of said second splitter have substantially the same power.
